(19) Europäisches Patentamt / European Patent Office / Office européen des brevets

(11) **EP 2 294 435 B1**

(12) **FASCICULE DE BREVET EUROPEEN**

(45) Date de publication et mention de la délivrance du brevet:
**15.01.2014 Bulletin 2014/03**

(21) Numéro de dépôt: **09784428.6**

(22) Date de dépôt: **24.06.2009**

(51) Int Cl.:
*G01R 31/302* *(2006.01)*     *G01R 31/315* *(2006.01)*
*G01R 31/265* *(2006.01)*

(86) Numéro de dépôt international:
**PCT/FR2009/051204**

(87) Numéro de publication internationale:
**WO 2010/004167 (14.01.2010 Gazette 2010/02)**

(54) **PROCÉDÉ ET MACHINE DE TEST MULTIDIMENSIONNEL D'UN DISPOSITIF ÉLECTRONIQUE À PARTIR D'UNE SONDE MONODIRECTIONNELLE**

VERFAHREN UND MASCHINE ZUM MEHRDIMENSIONALEN TESTEN EINER ELEKTRONISCHEN VORRICHTUNG AUF GRUNDLAGE EINER MONODIREKTIONALEN SONDE

METHOD AND MACHINE FOR MULTIDIMENSIONAL TESTING OF AN ELECTRONIC DEVICE ON THE BASIS OF A MONODIRECTIONAL PROBE

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **25.06.2008   FR 0803567**

(43) Date de publication de la demande:
**16.03.2011   Bulletin 2011/11**

(73) Titulaire: **Centre National d'Etudes Spatiales (C.N.E.S.)**
**75039 Paris Cedex 01 (FR)**

(72) Inventeur: **PERDU, Philippe**
**F-31100 Toulouse (FR)**

(74) Mandataire: **Cabinet BARRE LAFORGUE & associés**
**35, rue Lancefoc**
**31000 Toulouse (FR)**

(56) Documents cités:
FR-A1- 2 860 879        US-A1- 2003 001 596
US-A1- 2005 057 246

- **INFANTE F: "Failure Analysis for System in Package devices using Magnetic Microscopy" THESIS,, 21 mai 2008 (2008-05-21), page 198PP, XP009114669**
- **PERDU PHILIPPE: "Hardware and software for magnetic microscopy applied to 3D packages." CNES (CENTRE NATIONAL D'ETUDES SPATIALES) FULL CONTROL 2007, [Online] juillet 2007 (2007-07), XP002522036 Extrait de l'Internet: URL:http://mikro.ee.tu-berlin.de/hlb/Toulo use/full%20control.pdf> [extrait le 2009-03-25]**
- **CRÉPEL AND R DESPLATS AND Y BOUTTEMENT AND P PERDU AND C GOUPIL AND P DESCAMPS AND F BEAUDOIN AND L MARINA O: "Magnetic emission mapping for passive integrated components characterisation, journal = Microelectronics Reliability" MICROELECTRONICS AND RELIABILITY, ELSEVIER SCIENCE LTD, GB, vol. 43, no. 9-11, 1 janvier 2003 (2003-01-01), pages 1809-1814, XP007907929 ISSN: 0026-2714**
- **ANONYMOUS: "Scarica "Micro Electro Mechanical Systems (MEMS): A Ready Vision To Technology" gratis" EILASTUDENTI.NET (APUNTI, RIASSUNTI E TESINE PER STUDENTI), [Online] 11 juin 2008 (2008-06-11), XP002522037 Extrait de l'Internet: URL:http://eilastudenti.net/tema4248/micro -electro-mechanical-systems-mems-a-ready-v ision-to-technology.html> [extrait le 2009-03-25]**

EP 2 294 435 B1

- ANONYMOUS: "Scarica "Failure Analysis for System in Package devices using Magnetic Microscopy" gratis" EILASTUDENTI.NET (APUNTI, RIASSUNTI E TESINE PER STUDENTI), [Online] 25 mai 2008 (2008-05-25), XP002522038 Extrait de l'Internet: URL:http://eilastudenti.net/tema1684/failu re-analysis-for-system-in-package-devices- using-magnetic-microscopy.html> [extrait le 2009-03-25]

- Digital-Detective.Co.Uk: "WebDate - screenshot establishing the date of the latest modification of the webpage of XP002522036", WEBDATE, 15 October 2010 (2010-10-15), XP55042977, Retrieved from the Internet: URL:http://mikro.ee.tu-berlin.de/hlb/Toulo use/full%20control.pdf [retrieved on 2012-11-02]

**Description**

L'invention concerne un procédé et une machine de test d'un dispositif électronique.

Dans tout le texte, l'expression « assemblage électronique » désigne tout ensemble d'un seul tenant de composants électroniques en plusieurs pièces reliées et réunies les unes aux autres selon un circuit électrique prédéterminé en présentant le plus souvent des bornes de connexion extérieures ; il peut s'agir par exemple de plaques de circuits imprimés (PCB), d'assemblages (dits SiP ou « System in Package ») de circuits intégrés (à composants actifs (microprocesseurs, mémoires,...) et/ou passifs (résistances, capacités, inductances...) et/ou microsystèmes (par exemple MEMS)) dans un seul boîtier, les différentes pièces étant montées les unes à côté des autres et/ou empilées et/ou noyées dans des structures multicouches ou autres ; les liaisons électriques dans ces assemblages électroniques, notamment entre les différentes pièces, peuvent être réalisées par l'intermédiaire de pistes conductrices, par soudures, par fils de connexion (« wire bonding »), par collage (« flipchip »)...

Les dispositifs électroniques tels que les circuits intégrés et les assemblages électroniques doivent pouvoir être testés, à des fins diverses, notamment pour la détection et la localisation de défauts, ou pour l'assistance à la conception ou la détermination de leurs caractéristiques.

Une des méthodes connues pour réaliser ces tests consiste à alimenter le dispositif électronique en énergie électrique et avec des signaux d'entrée prédéterminés (vecteurs de test), puis à effectuer des mesures sur le dispositif électronique en fonctionnement. En particulier, compte tenu des fortes miniaturisations et des très grands taux d'intégration des dispositifs électroniques modernes, les mesures sont le plus souvent réalisées sous microscopie. En outre, une des techniques de mesure non destructive envisagée consiste à détecter au moins un champ magnétique induit à proximité immédiate du dispositif électronique par la circulation des courants au sein de ce dispositif électronique. En particulier, on sait qu'il est possible de réaliser une imagerie des courants circulant dans le dispositif électronique à l'aide d'une sonde magnétique (telle qu'un capteur magnétorésistif ou un capteur SQUID « superconducting quantum interference device ») disposée à proximité du dispositif. Une telle sonde permet d'évaluer une composante Bz du champ magnétique selon un axe ZZ' fixe prédéterminé par rapport à la sonde (correspondant en général à un axe longitudinal de la sonde) et permet de réaliser une imagerie bidimensionnelle de la composante Bz selon un plan orthogonal à l'axe ZZ' de la sonde. A partir de cette image bidimensionnelle du champ magnétique supposée parallèle à l'objet observé considéré être d'épaisseur nulle, on peut évaluer par calcul la distribution bidimensionnelle des courants circulant sur cet objet.

Néanmoins, les dispositifs électroniques modernes tels que les assemblages électroniques sont de plus en plus souvent conçus en trois dimensions. Une telle sonde dont l'efficacité suppose que l'épaisseur de l'objet mesuré soit négligeable par rapport à la distance entre la sonde et l'objet, n'est pas adaptée pour évaluer et réaliser une imagerie des courants qui sont éloignés de la sonde, au sein de l'épaisseur du dispositif électronique.

La solution qui a été envisagée pour résoudre ce problème (INFANTE F : « Failure Analysis for System in Package devices using Magnetic Microscopy » THESIS XP009114669 (date de publication 21 mai 2008; US2003/001596), consiste à réaliser plusieurs mesures sur différentes faces du dispositif électronique, une sonde étant orientée selon différents axes orthogonaux les uns aux autres, de façon à obtenir différentes images en deux dimensions qui, par combinaison entre elles et reconstructions, pourraient permettre d'obtenir une évaluation des courants. Néanmoins, une telle méthode par combinaison d'images bidimensionnelles ne permet pas de prendre en compte toutes les situations pouvant être rencontrées en trois dimensions au sein du circuit, par exemple dans le cas de la présence de plusieurs lignes conductrices ni coplanaires ni orthogonales entre elles, ou de lignes conductrices s'étendant non parallèlement aux plans détectés par la sonde ou en boucles, ou lorsque le dispositif électronique n'est pas en forme de cube. En outre, la réalisation de mesures selon trois directions orthogonales en regard de trois faces orthogonales du dispositif électronique suppose une machine de mesure particulièrement complexe comprenant trois sondes orthogonales, ou des manipulations successives du dispositif électronique pour présenter en regard de la sonde différentes faces de ce dispositif électronique, ce qui est à la fois long et peu fiable.

Dans ce contexte, l'invention vise à proposer un procédé et une machine de test permettant, à partir d'une sonde de mesure de type monodirectionnelle, d'obtenir une mesure non limitée à la composante axiale Bz du champ magnétique émis par le dispositif électronique.

Plus particulièrement, l'invention vise à proposer un procédé et une machine de test permettant de réaliser des mesures permettant d'évaluer la circulation des courants non seulement dans le plan orthogonal à l'axe ZZ' de la sonde, mais également selon au moins un plan parallèle à cet axe ZZ'.

En particulier, l'invention vise à proposer un tel procédé et une telle machine qui permettent d'obtenir avec une grande fiabilité et une grande précision, une représentation des trois composantes du champ magnétique induit par la circulation en trois dimensions des courants dans le dispositif électronique, à partir uniquement de mesures réalisées par une sonde monodirectionnelle disposée en regard d'une seule face du dispositif électronique.

L'invention vise également plus particulièrement à proposer un tel procédé et une telle machine qui puissent être utilisés pour la détection et la localisation de défauts dans les dispositifs électroniques de type tridimensionnel, par exemple les assemblages électroniques.

Pour ce faire, l'invention concerne un procédé de test d'un dispositif électronique, dans lequel le champ magnétique émis par au moins une circulation de courant électrique dans le dispositif électronique est mesuré par une sonde de mesure monodirectionnelle adaptée pour pouvoir délivrer un signal représentatif de la valeur d'une composante Bz dudit champ magnétique selon un axe ZZ' fixe prédéterminé par rapport à ladite sonde:

- la sonde étant approchée à une distance d0 en regard d'une face du dispositif électronique avec l'axe ZZ' sécant avec le dispositif électronique, et le dispositif électronique étant alimenté en énergie électrique et avec des signaux d'entrée prédéterminés appliqués sur des bornes d'entrées du dispositif électronique, pour chaque position (x, y) de l'axe ZZ' par rapport à la dite face, une première valeur Bz1 de la composante Bz du champ magnétique selon l'axe ZZ' est mesurée par la sonde et enregistrée,

caractérisé en ce que

- puis la sonde et le dispositif électronique sont déplacés l'un par rapport à l'autre par pivotement relatif autour d'un axe XX' orthogonal à l'axe ZZ' selon une amplitude angulaire inférieure à 90°, la sonde étant maintenue à la même distance d0 en regard de la même face du dispositif électronique, et, le dispositif électronique étant alimenté en énergie électrique et avec des signaux d'entrée prédéterminés, pour chaque position (x, y) de l'axe ZZ' par rapport à la dite face, une deuxième valeur Bz2 de la composante Bz du champ magnétique selon l'axe ZZ' est mesurée par la sonde et enregistrée,
- puis la valeur d'une composante By du champ magnétique selon un axe YY' orthogonal aux axes ZZ' et XX' est déterminée et enregistrée à partir de la première valeur Bz1 et de la deuxième valeur Bz2 obtenues.

L'invention part en effet du constat selon lequel à partir de deux mesures d'une même composante Bz du champ magnétique réalisées avec deux positions angulaires différentes (de moins de 90° -notamment de moins de 45°- entre elles) du dispositif électronique par rapport à la sonde selon un axe XX' orthogonal à l'axe ZZ' de la sonde, il est possible de calculer la valeur d'une deuxième composante By du champ magnétique.

En outre, en faisant pivoter l'un par rapport à l'autre le dispositif électronique et la sonde selon un troisième axe YY' orthogonal aux deux premiers (et uniquement selon ce troisième axe YY', une direction qui passe par la face du dispositif électronique, et qui est orthogonale au deuxième axe XX' étant orthogonale à l'axe ZZ', le dispositif électronique n'étant pas pivoté autour dudit deuxième axe XX' par rapport à sa position de mesure de la première valeur Bz1 de la composante Bz du champ magnétique), il est possible également de calculer la valeur d'une troisième composante Bx du champ magnétique. Ainsi, avantageusement, un procédé selon l'invention est aussi caractérisé en ce que :

- la sonde et le dispositif électronique sont déplacés l'un par rapport à l'autre par pivotement relatif autour de l'axe YY' selon une amplitude angulaire inférieure à 90°, la sonde étant maintenue à la même distance d0 en regard de la même face du dispositif électronique, et, le dispositif électronique étant alimenté en énergie électrique et avec des signaux d'entrée prédéterminés, pour chaque position (x, y) de l'axe ZZ' par rapport à la dite face, une troisième valeur Bz3 de la composante Bz du champ magnétique selon l'axe ZZ' est mesurée par la sonde et enregistrée,
- puis la valeur d'une composante Bx du champ magnétique selon l'axe XX' est déterminée et enregistrée à partir de la première valeur Bz1 et de la troisième valeur Bz3 obtenues.

Un procédé de test selon l'invention peut-être en particulier appliqué pour la détection et la localisation de défauts dans le circuit électrique du dispositif électronique.

Ainsi, un procédé selon l'invention est avantageusement également caractérisé en ce que :

- une image, dite image mesurée, d'au moins une partie du dispositif électronique est élaborée à partir de l'une des trois composantes Bx, By, Bz du champ magnétique émis par ce dispositif électronique, telle que déterminée à partir des mesures fournies par ladite sonde pour différentes positions (x, y) de l'axe ZZ' de la sonde par rapport à la dite face,
- une pluralité d'images simulées de ladite partie du dispositif électronique sont élaborées par simulation, chaque image simulée correspondant à une image susceptible d'être obtenue de la même façon que l'image mesurée, à partir de valeurs calculées par simulation, pour chaque position (x, y) de l'axe ZZ' par rapport à la dite face, de la composante Bx, By, Bz correspondante du champ magnétique tel qu'il serait émis par ce dispositif électronique en présence d'au moins un défaut de la circulation de courant dans ladite partie du dispositif électronique,
- les images simulées sont comparées à l'image mesurée.

Cette comparaison peut être effectuée par un utilisateur humain (comparaisons visuelles) ou au contraire automatiquement, par exemple grâce à un logiciel de traitement et de comparaisons d'images (par exemple le logiciel de traitement d'images WIT® de la société DALSA Digital Imaging (Burnaby, Canada). Il est à noter à cet égard que le fait de réaliser des images simulées et de comparer ces images simulées à l'image mesurée permet de s'affranchir de tout calcul de l'intensité du courant à partir des valeurs des composantes du champ magnétique, calcul qui n'a pas toujours de solution analytique simple. En outre, cette comparaison d'images permet de s'affranchir des défauts de mesure dus au principe même de cette mesure, notamment les défauts provenant de la distance qui existe nécessairement entre la sonde et le dispositif électronique, puisque ces défauts se retrouvent aussi bien sur l'image mesurée que sur les images simulées.

En choisissant de façon appropriée les différentes images simulées, en fonction de la nature du circuit électrique, il est possible de localiser rapidement un défaut dans le circuit électrique.

En particulier, avantageusement et selon l'invention, l'image mesurée de ladite partie du dispositif électronique utilisée pour la comparaison correspond à une soustraction d'une image (ou de la matrice correspondante) obtenue à partir de la composante Bx, By, Bz correspondante mesurée du champ magnétique émis par l'intégralité d'un dispositif électronique de référence correspondant au dispositif électronique à tester mais exempt de défauts, cette composante étant mesurée pour chaque position (x, y) de l'axe ZZ' par rapport à la dite face, et d'une image (ou de la matrice correspondante) obtenue à partir de la composante Bx, By, Bz correspondante mesurée du champ magnétique émis par l'intégralité du dispositif électronique à tester, cette composante étant aussi mesurée pour chaque position (x, y) de l'axe ZZ' par rapport à la dite face, et chaque image simulée est élaborée par soustraction d'une image (ou de la matrice correspondante) obtenue à partir de valeurs calculées par simulation, pour chaque position (x, y) de l'axe ZZ' par rapport à la dite face, de la composante Bx, By, Bz correspondante du champ magnétique tel qu'il serait émis par l'intégralité du dispositif électronique de référence, et d'une image (ou de la matrice correspondante) obtenue à partir de valeurs calculées par simulation, pour chaque position (x, y) de l'axe ZZ' par rapport à la dite face, de la composante Bx, By, Bz correspondante du champ magnétique tel qu'il serait émis par l'intégralité du dispositif électronique en présence d'au moins un défaut. De la sorte, toutes les parties du dispositif électronique, et donc des images correspondantes, qui sont exemptes de défauts, sont soustraites et ne sont pas utilisées dans la comparaison, qui est donc particulièrement simple, précise et rapide.

Rien n'empêche, en variante, d'utiliser d'autres procédés pour choisir les portions de circuit à simuler. Par exemple, dans le cas de circuits complexes, il est possible d'émettre des hypothèses par itérations sur des portions de volume du dispositif électronique susceptibles de contenir au moins un défaut, et de n'effectuer, à chaque itération, des simulations et une comparaison que sur une portion de volume. A l'inverse, dans le cas de circuits simples, l'image mesurée et chaque image simulée peuvent correspondre à l'intégralité du dispositif électronique.

Avantageusement et selon l'invention, on utilise une sonde de mesure comprenant un capteur choisi parmi un capteur SQUID et un capteur magnétorésistif.

Par ailleurs, un procédé selon l'invention est avantageusement aussi caractérisé en ce que le dispositif électronique étant un assemblage électronique en trois dimensions, pour mesurer ladite première valeur Bz1, la sonde est orientée avec l'axe ZZ' orthogonal à l'une des faces externes de cet assemblage électronique -notamment à une face principale (face supérieure ou inférieure de plus grande dimension) de cet assemblage électronique-.

Dans un procédé selon l'invention, pour faire pivoter l'un par rapport à l'autre la sonde et le dispositif électronique, il est possible soit de déplacer la sonde par rapport à un bâti sur lequel le dispositif électronique est maintenu fixe, soit de déplacer le dispositif électronique par rapport à un bâti par rapport auquel au moins l'orientation de l'axe ZZ' de la sonde est maintenue fixe, soit de déplacer simultanément à la fois la sonde et le dispositif électronique par rapport à un bâti commun.

Avantageusement et selon l'invention, la sonde et le dispositif électronique sont déplacés l'un par rapport à l'autre par pivotement relatif selon une amplitude angulaire supérieure à 10° et inférieure à 45 ° -notamment comprise entre 10° et 30°-.

L'invention s'étend à une machine de test adaptée pour la mise en oeuvre d'un procédé de test selon l'invention.

L'invention concerne ainsi également une machine de test d'un dispositif électronique, comprenant :

- une sonde de mesure monodirectionnelle adaptée pour pouvoir délivrer un signal représentatif de la valeur d'une composante Bz selon un axe ZZ' fixe prédéterminé par rapport à ladite sonde, du champ magnétique émis au voisinage de la sonde par au moins une circulation de courant électrique dans le dispositif électronique,
- un support de réception d'un dispositif électronique, et des moyens d'alimentation de ce dispositif électronique en énergie électrique et avec des signaux d'entrée prédéterminés appliqués sur des bornes d'entrées du dispositif électronique,
- un mécanisme apte à placer l'un par rapport à l'autre la sonde et un dispositif électronique reçu dans le support de réception, avec l'axe ZZ' sécant avec le dispositif électronique,
- des moyens d'enregistrement des valeurs correspondant aux signaux délivrés par la sonde,

caractérisée en ce que :

- ledit mécanisme est adapté pour permettre de modifier, pour chaque position (x, y) de l'axe ZZ' par rapport au dispositif électronique, l'orientation de la sonde et du dispositif électronique l'un par rapport à l'autre, par pivotement relatif autour d'un axe XX' orthogonal à l'axe ZZ' selon une amplitude angulaire inférieure à 90°, la sonde étant maintenue à une distance d0 en regard d'une même face du dispositif électronique,

- elle comprend des moyens de calcul adaptés pour déterminer et enregistrer, pour chaque position (x, y) de l'axe ZZ' par rapport à la dite face, la valeur d'une composante By du champ magnétique selon un axe YY' orthogonal aux axes ZZ' et XX', à partir d'une première valeur Bz1 de la composante Bz du champ magnétique selon l'axe ZZ' mesurée par la sonde dans une première position angulaire relative par rapport à l'axe XX' de la sonde et du dispositif électronique, et d'une deuxième valeur Bz2 de la composante Bz du champ magnétique selon l'axe ZZ' mesurée par la sonde dans une deuxième position angulaire relative par rapport à l'axe XX' de la sonde et du dispositif électronique, et à la même distance d0, lesdites première et deuxième positions angulaires par rapport à l'axe XX' étant séparées l'une de l'autre d'un angle inférieur à 90°-notamment inférieur à 45°-.

Avantageusement et selon l'invention, ledit mécanisme est aussi adapté pour permettre de modifier l'orientation de la sonde et du dispositif électronique l'un par rapport à l'autre par pivotement relatif autour de l'axe YY' selon une amplitude angulaire inférieure à 90°, la sonde étant maintenue à la même distance d0 en regard de la même face du dispositif électronique, et lesdits moyens de calcul sont adaptés pour pouvoir déterminer et enregistrer, pour chaque position (x, y) de l'axe ZZ' par rapport à la dite face, la valeur d'une composante Bx du champ magnétique selon l'axe XX', à partir d'une première valeur Bz1 de la composante Bz du champ magnétique selon l'axe ZZ' mesurée par la sonde dans une première position angulaire relative par rapport à l'axe YY' de la sonde et du dispositif électronique, et d'une troisième valeur Bz3 de la composante Bz du champ magnétique selon l'axe ZZ' mesurée par la sonde dans une deuxième position angulaire relative par rapport à l'axe YY' de la sonde et du dispositif électronique, et à la même distance d0, lesdites première et deuxième positions angulaires par rapport à l'axe YY' étant séparées l'une de l'autre d'un angle inférieur à 90°.

En outre, avantageusement et selon l'invention, ladite sonde de mesure comprend un capteur choisi parmi un capteur SQUID et un capteur magnétorésistif.

Avantageusement, une machine selon l'invention, comprend en outre :

- des moyens de génération d'une image, dite image mesurée, à partir de l'une des trois composantes Bx, By, Bz du champ magnétique émis par ce dispositif électronique, telle que déterminée à partir des mesures fournies par ladite sonde pour différentes positions (x, y) de l'axe ZZ' de la sonde par rapport à la dite face,

- des moyens de calcul par simulation de valeurs calculées, pour chaque position (x, y) de l'axe ZZ' par rapport à la dite face, des trois composantes Bx, By, Bz du champ magnétique tel qu'il serait émis par ladite partie du dispositif électronique en présence d'au moins un défaut de la circulation de courant dans ladite partie du dispositif électronique,
- des moyens de génération d'une pluralité d'images simulées de ladite partie du dispositif électronique par simulation, chaque image simulée correspondant à une image susceptible d'être obtenue de la même façon que l'image mesurée, à partir d'un jeu desdites valeurs calculées par simulation, pour chaque position (x, y) de l'axe ZZ' par rapport à la dite face, de la composante Bx, By, Bz correspondante du champ magnétique.

Par ailleurs, avantageusement et selon l'invention :

- le support de réception est adapté pour pouvoir recevoir un dispositif électronique formé d'un assemblage électronique en trois dimensions,
- le mécanisme est adapté pour permettre d'orienter la sonde avec l'axe ZZ' orthogonal à l'une des faces externes d'un assemblage électronique reçu dans ledit support.

Dans une première variante, avantageusement et selon l'invention, le support de réception du dispositif électronique est fixe par rapport à un bâti et ledit mécanisme est adapté pour permette de faire pivoter la sonde par rapport à ce bâti. Dans une deuxième variante, avantageusement et selon l'invention, la sonde est montée par rapport à un bâti de façon à présenter une orientation de l'axe ZZ' fixe par rapport au bâti, ledit mécanisme est adapté pour permettre de faire pivoter par rapport au bâti le support de réception du dispositif électronique, et le dispositif électronique reçu dans le support est alimenté par l'intermédiaire d'un câble torsadé.

L'invention concerne également un procédé et une machine de test caractérisés en combinaison par tout ou partie des caractéristiques mentionnées ci-dessus ou ci-après.

D'autres buts, caractéristiques et avantages de l'invention apparaîtront à la lecture de la description suivante de plusieurs de ses modes de réalisation préférentiels donnés uniquement à titre d'exemples non limitatifs et qui se réfère aux figures annexées dans lesquelles :

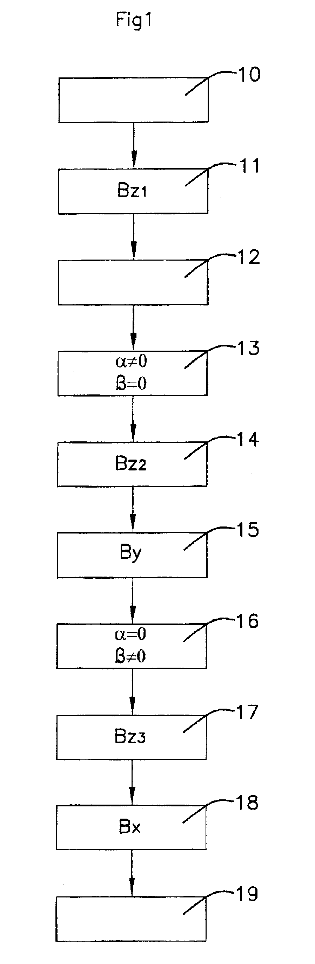

- la figure 1 est un organigramme général d'un procédé de test selon un mode de réalisation de l'invention,
- la figure 2 est un organigramme illustrant un procédé selon l'invention permettant la détection et la localisation de défauts par comparaison d'images,

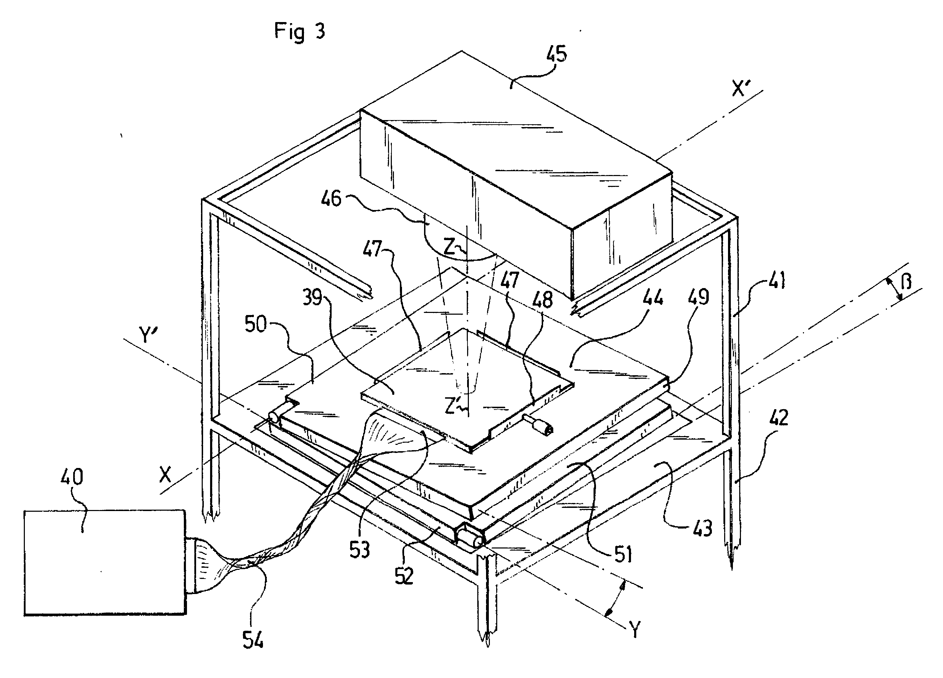

- la figure 3 est une représentation schématique d'une machine de test selon l'invention,
- les figures 4a et 4b sont des schémas de principe illustrant respectivement les deux positions de mesure des valeurs Bz1 et Bz2, la figure 4b illustrant le calcul d'une composante By du champ magnétique,
- la figure 5a est un schéma en perspective représentant un exemple d'assemblage électronique, et la figure 5b est un schéma en perspective éclatée représentant le circuit électrique du même assemblage électronique,
- la figure 6 représente un exemple d'image mesurée obtenue avec un procédé selon l'invention avec l'assemblage électronique des figures 5a et 5b,
- les figures 7a, 7b, 7c sont des schémas en perspective éclatée représentant trois exemples d'hypothèses de défauts dans le circuit électrique de l'assemblage électronique, et les figures 8a, 8b, 8c représentent des exemples d'images simulées correspondantes.

Une machine de test selon l'invention est globalement constituée d'une machine connue, par exemple un microscope magnétique tel que commercialisé sous la référence Magma C30® par la société NEOCERA (Beltsville, Maryland, USA), cette machine étant modifiée comme indiqué ci-après pour la mise en oeuvre d'un procédé selon l'invention. En conséquence, seules les principales caractéristiques et les caractéristiques spécifiques de l'invention sont décrites ci-après, les autres caractéristiques générales d'une machine de test de dispositifs électroniques étant connues en elles-mêmes.

Une machine 4 de test selon l'invention comprend un bâti 41 fixe principal reposant sur le sol par des pieds 42, et portant en particulier une table 43 horizontale de travail sur laquelle est monté un support 44 de réception d'un dispositif électronique à tester 39. Le bâti 41 porte également une console 45 supérieure portant et guidant, à distance et au-dessus du support 44 de réception, une sonde 46 de mesure monodirectionnelle de champ magnétique, notamment comprenant un capteur SQUID d'axe vertical (orthogonal à la table 43 support). La sonde 46 de mesure est adaptée pour pouvoir délivrer un signal représentatif de la valeur d'une composante Bz selon un axe fixe ZZ' prédéterminé par rapport à ladite sonde 46. De préférence, dans le mode de réalisation, l'axe ZZ' est vertical, mais rien n'empêche de prévoir que l'axe de la sonde 46 soit disposé selon tout autre orientation, dès lors que cet axe ZZ' puisse être sécant avec le support 44 de réception, et donc avec un dispositif électronique disposé dans ce support 44 de réception.

La machine 4 de test selon l'invention comprend également un mécanisme adapté pour pouvoir placer et orienter l'un par rapport à l'autre la sonde 46, et plus particulièrement l'axe ZZ', et un dispositif électronique reçu et fixé dans le support 44 de réception.

Ce mécanisme comprend tout d'abord des moyens motorisés, bien connus en eux-mêmes (cf. par exemple machine Magma C30® susmentionnée), permettant de déplacer l'un par rapport à l'autre la sonde et le support 44 de réception en translation selon trois axes orthogonaux, c'est-à-dire d'une part dans un plan horizontal (XX', YY') parallèle à la table 43 et, d'autre part, parallèlement à l'axe ZZ' vertical de la sonde 46. Par exemple, ces moyens motorisés de déplacement et de positionnement font partie de la console 45 portant la sonde 46, cette console 45 comprenant un portique comportant un longeron horizontal principal porté et guidé en translation entre deux traverses horizontales, la sonde 46 étant elle-même guidée en translation le long du longeron principal, et incorporant un montant de guidage vertical du capteur magnétique, les différents mouvements étant motorisés à partir d'une pluralité de moteurs électriques associés à des codeurs permettant de repérer la position précise du capteur de la sonde 46 par rapport au bâti 41.

Le support 44 de réception comprend une bride 47, 48 de fixation d'un dispositif électronique, cette bride comportant deux butées 47 fixes horizontales et orthogonales l'une par rapport à l'autre permettant de caler le dispositif électronique dans le plan horizontal par rapport au support 44 de réception, et, d'autre part, au moins une butée 48 mobile, montée, par rapport à la table 43, mobile horizontalement en regard de l'une des butées 47 fixes de façon à permettre le serrage du dispositif électronique.

Ce support 44 de réception est par ailleurs porté par un plateau mobile 49 d'une première table pivotante 50 autour d'un premier axe horizontal XX', elle-même portée par le plateau mobile 51 d'une deuxième table pivotante 52 autour d'un deuxième axe horizontal YY' orthogonal au précédent, de sorte que le support 44 de réception peut être incliné par rapport au plan horizontal de la table de travail 43 selon un angle prédéterminé $\alpha$ autour de l'axe horizontal XX' et/ou selon un angle prédéterminé $\beta$ autour de l'axe horizontal YY'.

Chaque table pivotante 50, 52 permet de maintenir fixe l'angle d'inclinaison $\alpha$ ou $\beta$ du support 44 de réception autour de l'axe horizontal XX' ou YY' correspondant. Une telle table pivotante 50 ou 52 peut être à commande manuelle et/ou motorisée par un moteur électrique, et est bien connue en elle-même.

La machine 4 de test selon l'invention comprend également un automate 40 de contrôle permettant d'une part de commander les différents mouvements de la sonde 46 et du support 44 de réception en translations et en inclinaisons, d'autre part de piloter le fonctionnement général de la machine. Cet automate 40 de contrôle est relié d'une part à la sonde 46 de mesure, d'autre part à au moins un connecteur 53 pouvant être relié à un dispositif électronique porté dans le support 44 de réception. Cet automate 40 de contrôle comprend un dispositif informatique comprenant en particulier une mémoire de masse permettant l'enregistrement de valeurs correspondant aux signaux délivrés par la sonde 46.

L'automate 40 de contrôle est en particulier adapté pour pouvoir élaborer des signaux de test prédéterminés délivrés sur les entrées du dispositif électronique reçu dans le support 44 de réception. Ces signaux de test sont élaborés en fonction de chaque dispositif électronique, de façon bien connue en soi, par exemple grâce à un testeur de composants tel que le testeur référence D 10 commercialisé par la société CREDENCE SYSTEM CORPORATION (Milpitas, USA), qui fait partie de l'automate 40. En variante, un logiciel de pilotage d'instrumentation de type GPIB (par exemple le logiciel Labview® commercialisé par la Société National Instruments, France (Le Blanc-Mesnil, France) peut être utilisé, en association à des circuits d'alimentation, des voltmètres, des ampèremètres, par exemple tels que commercialisés par la société Agitent Technologies France (Massy, France).

Par ailleurs, la machine 4 de test selon l'invention est adaptée pour pouvoir effectuer des calculs et des traitements numériques, notamment d'imagerie, à partir des signaux délivrés par la sonde 46 monodirectionnelle magnétique, comme indiqué ci-après, pour la mise en oeuvre d'un procédé de test selon l'invention. Pour ce faire, l'automate 40 de contrôle informatique peut être programmé à cet effet de toute façon appropriée.

Dans la première étape 10 d'un procédé selon l'invention, on met en place et on fixe un dispositif électronique à tester 39 sur le support 44 de réception d'une machine 4 de test selon l'invention. De préférence, on place le dispositif électronique de façon à ce qu'il présente une grande face principale orientée vers le haut horizontalement. Les tables pivotantes 50, 52 sont placées à angles $\alpha$ et $\beta$ nuls, le support 44 de réception et le dispositif électronique étant horizontaux.

On approche ensuite la sonde de mesure à une distance d0 du dispositif électronique, et, pour chaque position de l'axe ZZ' fixe dans le plan horizontal, c'est-à-dire pour chaque couple de coordonnées (x, y) de cet axe ZZ', on réalise une première mesure de la composante Bz du champ magnétique émis par le dispositif électronique, ce dernier, relié au connecteur 53, étant alimenté par des signaux de test appropriés sur ses entrées de façon à générer des courants dans son circuit électrique, au moins dans les parties de ce circuit électrique que l'on souhaite tester. On obtient alors une première valeur Bz1(x, y) de la composante Bz du champ magnétique, que l'on enregistre.

On déplace la sonde 46 dans le plan horizontal, en faisant varier x et y de façon à parcourir tout le circuit, en conservant la même distance d0, et on mesure et on enregistre pour chaque position (x, y) la première valeur Bz1(x, y) de la composante Bz du champ magnétique (étape 11).

Le nombre de mesures réalisées dans le plan, c'est-à-dire les pas de variation de la coordonnée x (selon l'axe XX') et de la coordonnée y (selon l'axe YY'), sont choisis pour pouvoir obtenir, lors de l'étape 12, à partir des différentes valeurs Bz1(x, y), une image bidimensionnelle, selon un plan orthogonal à l'axe ZZ', représentative de la composante Bz du champ magnétique émis par au moins une portion prédéterminée du circuit. Une telle image peut être obtenue de façon connue en soi, par exemple à l'aide du logiciel intégré dans la machine Magma C30® susmentionnée.

Lors de l'étape 13 subséquente, on fait pivoter la première table pivotante 50, et donc on incline le support 44 de réception et le dispositif électronique d'un angle $\alpha$ prédéterminé par rapport à l'axe XX', de valeur supérieure à 10°, de préférence comprise entre 10° et 30°. Une valeur de $\alpha$ élevée augmente la précision du résultat du calcul, mais gêne l'approche de la sonde 46 à la distance d0 appropriée du dispositif électronique. On maintient par contre $\beta$=0 (pas d'inclinaison autour de l'axe YY').

Dans cette position, on réitère (étape 14) la mesure de la composante Bz du champ magnétique comme indiqué ci-dessus, en maintenant le capteur de la sonde 46 de mesure à la même distance d0 du dispositif électronique, et en parcourant les mêmes positions (x, y) du plan horizontal que dans l'étape 11. Il est à noter que la hauteur de la sonde 46 de mesure par rapport à la table 43 de travail doit être modifiée lorsque la sonde 46 est déplacée selon l'axe YY', pour maintenir la sonde 46 à la distance d0 constante compte tenu de l'inclinaison $\alpha$.

On mesure et on enregistre donc, lors de l'étape 14, pour chaque position (x, y), une deuxième valeur Bz2 (x, y) de la composante Bz du champ magnétique.

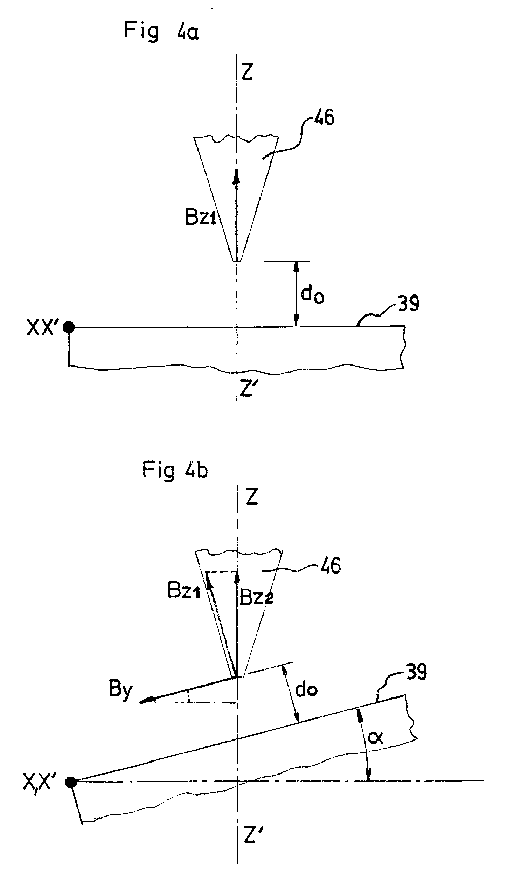

Comme on le voit figure 4b, on a par construction :

$$Bz2 = Bz1.\cos\alpha - By.\sin\alpha$$

On peut donc en déduire, lors de l'étape 15, pour chaque position (x, y), la valeur de la composante By du champ magnétique selon l'axe YY' par la formule :

$$By = (Bz1.\cos\alpha - Bz2)/\sin\alpha$$

Cette valeur de la composante By du champ magnétique est enregistrée par l'automate 40.

De même, lors de l'étape 16 subséquente, on fait pivoter la deuxième table pivotante 52, et donc on incline le support 44 de réception et le dispositif électronique d'un angle $\beta$ prédéterminé par rapport à l'axe YY', de valeur supérieure à 10°, de préférence comprise entre 10° et 30°. Une valeur de $\beta$ élevée augmente la précision du résultat du calcul, mais gêne l'approche de la sonde 46 à la distance d0 appropriée du dispositif électronique. On rétablit par contre $\alpha$=0 (pas d'inclinaison autour de l'axe XX').

Dans cette position, on réitère (étape 17) la mesure de la composante Bz du champ magnétique comme indiqué ci-dessus, en maintenant le capteur de la sonde 46 de mesure à la même distance d0 du dispositif électronique, et en parcourant les mêmes positions (x, y) du plan horizontal que dans l'étape 11. La hauteur de la sonde 46 de mesure par rapport à la table de travail doit aussi être modifiée lorsque la sonde 46 est déplacée selon l'axe XX', pour maintenir d0 constante compte tenu de l'inclinaison β.

On mesure et on enregistre donc, lors de l'étape 17, pour chaque position (x, y), une troisième valeur Bz3 (x, y) de la composante Bz du champ magnétique.

Comme précédemment, on a :

$$Bz3 = Bz1.\cos\beta - Bx.\sin\beta$$

On peut donc en déduire, lors de l'étape 18, pour chaque position (x, y), la valeur de la composante Bx du champ magnétique selon l'axe XX' par la formule :

$$Bx = (Bz1.\cos\beta - Bz3)/\sin\beta$$

Cette valeur de la composante Bx du champ magnétique est enregistrée par l'automate 40.

Les calculs des composantes By et Bx selon l'invention supposent que les valeurs du champ magnétique émis par le dispositif électronique ne soient pas modifiées par l'inclinaison α ou β. Dans le mode de réalisation représenté et décrit ci-dessus, dans lequel le support 44 de réception, et donc le dispositif électronique, sont déplacés pour générer l'inclinaison correspondante, de préférence, l'alimentation du dispositif électronique est réalisée par l'intermédiaire d'un câble 54 torsadé aboutissant au connecteur 53, de sorte que le courant électrique circulant dans ce câble 54 ne modifie pas le champ magnétique du fait de l'inclinaison.

Dans une variante de réalisation non représentée, il est possible au contraire de maintenir le support 44 de réception et le dispositif électronique fixes dans un plan horizontal, et de réaliser les inclinaisons α et β autour des axes XX' et YY' en modifiant l'orientation de l'axe de la sonde 46 de mesure par rapport au bâti 41, cette sonde 46 de mesure étant alors montée par rapport à la console 45 par des liaisons pivot de façon à pouvoir être inclinée autour de ces axes. De la sorte, le dispositif électronique n'étant pas déplacé entre les différentes étapes de mesure, le champ magnétique émis n'est pas modifié.

À l'issue des étapes 10 à 18 de mesure et de calcul, on obtient pour chaque composante Bx, By, Bz du champ magnétique émis par le dispositif électronique, une matrice [Bx (x, y, d0)], [By (x, y, d0)], [Bz (x, y, d0)] dans laquelle sont enregistrées, pour chaque position (x, y), les valeurs de ladite composante Bx, By, Bz. Chaque matrice peut être visualisée sous forme d'une image, les images mesurées ainsi obtenues de ces trois composantes étant représentatives des circulations du courant dans le dispositif électronique, et prenant en compte les circulations du courant dans les trois dimensions, quelles que soient les formes des lignes conductrices.

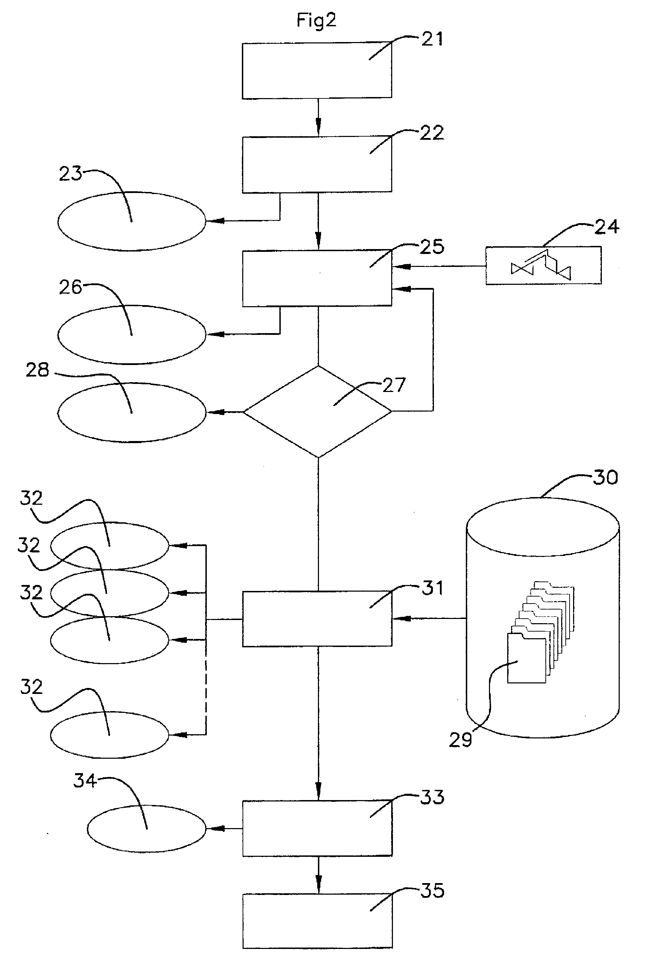

Une telle image mesurée peut être utilisée ensuite pour détecter et localiser un défaut dans le circuit électrique du dispositif électronique comme décrit ci-après en référence à la figure 2.

Lors de la première étape 21, on choisit un dispositif électronique de référence, dont le circuit électrique 24, de référence, est connu et exempt de défaut, et correspond au circuit électrique nominal du dispositif électronique à tester 39 dans lequel on souhaite détecter d'éventuels défauts.

Lors de l'étape 22 subséquente, on exécute les étapes 10 à 19 susmentionnées du procédé de test selon l'invention sur le dispositif électronique de référence, de façon à obtenir, pour chaque composante Bx, By, Bz du champ magnétique, une matrice et une image mesurée de référence 23.

À partir du circuit électrique 24 de référence qui est connu et à l'aide par exemple d'un logiciel de simulation approprié, tel que le logiciel d'analyse par éléments finis Flux 3D® commercialisé par la société CEDRAT Group (Meylan, France) ou le logiciel d'éléments de circuit BIO SAVART® commercialisé par la société RIPPLON (Burnaby, Canada), on calcule, lors de l'étape 25, les différentes composantes Bx, By, Bz, du champ magnétique tel qu'il serait émis par le dispositif électronique de référence, puis, pour chaque composante Bx, By, Bz, une image simulée de référence 26 correspondant à une image susceptible d'être obtenue de la même façon que l'image mesurée, mais à partir des valeurs des composantes Bx, By, Bz du champ magnétique précédemment calculées par simulation.

On exécute ensuite un test 27 dans lequel on vérifie que la calibration de la simulation est correcte, c'est-à-dire que l'image simulée de référence 26 correspondant à l'image mesurée de référence 23. Si tel n'est pas le cas, on réitère l'étape 25 de simulation en corrigeant les paramètres. Si la comparaison exécutée par le test 27 est considérée comme correcte, on enregistre le résultat 28 de cette comparaison entre les deux images 23 et 26 de référence.

L'utilisateur (opérateur humain) émet ensuite un certain nombre d'hypothèses sur l'éventuelle présence d'un défaut dans le circuit électrique du dispositif électronique à tester 39. Chaque hypothèse est représentée par un enregistrement 29 du circuit électrique dans une base de données 30. Pour chaque enregistrement 29, on exécute une étape de simulation 31 identique à l'étape 25 de simulation précédente, mais avec le circuit électrique contenant un défaut représenté par l'enregistrement 29. À l'issue de ces étapes de simulation, on obtient des images simulées, à savoir une image simulée 32 pour chaque hypothèse de défaut, c'est-à-dire pour chaque enregistrement 29.

Par ailleurs, lors de l'étape 33 qui peut être exécutée avant, après ou pendant les étapes de simulation 31, on exécute les étapes 10 à 19 du procédé de test selon l'invention mentionnées ci-dessus avec le dispositif électronique à tester 39, de façon à obtenir l'image mesurée 34 de ce dispositif électronique.

Lors de l'étape 35 subséquente, on compare chacune des images simulées 32 à l'image mesurée 34 de façon à déterminer l'image simulée 32 qui présente la meilleure corrélation avec l'image mesurée 34, c'est-à-dire un résultat de comparaison le plus proche du résultat 28 obtenu à partir du dispositif électronique de référence. Cette comparaison 35 peut être effectuée simplement de façon visuelle par l'utilisateur (opérateur humain), ou de façon entièrement automatique par un logiciel de comparaison image, ou, en combinaison de façon semi-automatique par un opérateur humain assisté par un logiciel de comparaison image. Par exemple, cette comparaison d'image peut être effectuée à l'aide du logiciel de traitement d'images WIT® de la société DALSA Digital Imaging (Burnaby, Canada).

Ainsi, l'utilisation d'images simulées obtenues en émettant différentes hypothèses sur les défauts possibles dans le circuit permet de détecter et de localiser un défaut dans un dispositif électronique grâce à un procédé de test selon invention, et ce en s'affranchissant de tout calcul analytique par intégration des composantes Bx, By, Bz du champ magnétique.

Par ailleurs, du fait que, dans le cadre de la mesure d'un champ magnétique, chaque contribution du circuit s'additionne aux autres, il est possible de s'affranchir dans l'ensemble du procédé selon l'invention, de la mesure et/ou de la simulation des parties du circuit électronique du dispositif électronique qui ne doivent pas être testées, notamment à raison du fait que ces parties sont nécessairement exemptes de défaut.

Pour ce faire, il est possible, en particulier, de calculer une image mesurée différentielle en soustrayant l'image mesurée 23 de référence de l'image mesurée 34 du dispositif électronique, et de calculer des images simulées différentielles en soustrayant l'image simulée 26 de référence de chaque image simulée 32, avant de procéder à la comparaison 35 uniquement sur ces images différentielles. Il est même possible de ne réaliser des images simulées que sur les parties de l'image mesurée différentielle présentant des valeurs non nulles. De la sorte, le procédé est grandement simplifié et accéléré.

EXEMPLE :

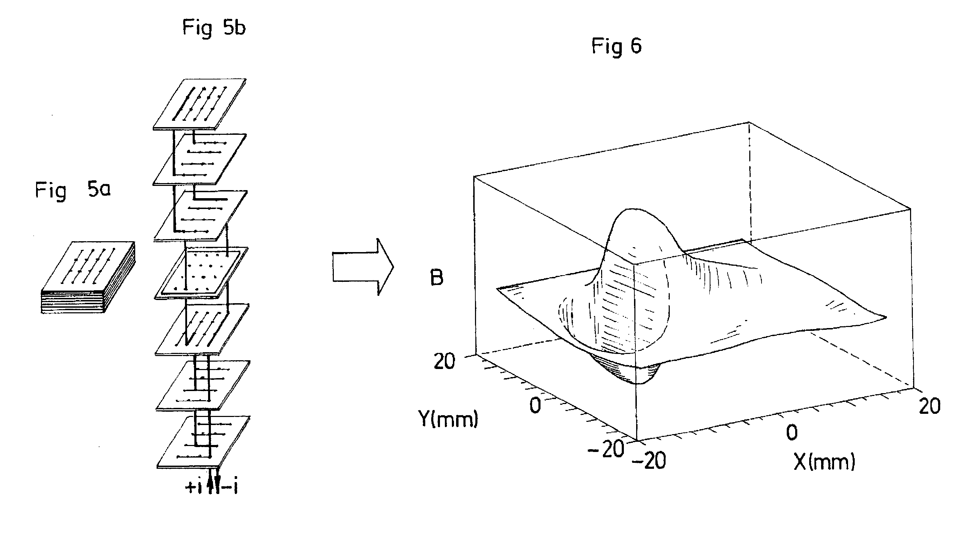

Dans l'exemple de la figure 5a, le dispositif électronique à tester est un assemblage électronique constitué d'un empilement de sept plaques rectangulaires représentées sur la figure 5b. Cet assemblage électronique présente un circuit électronique de référence représenté figure 5b par une circulation de courant électrique -i, +i selon des lignes de conduction passant par les différentes plaques.

La figure 6 représente une image mesurée de référence obtenue conformément à l'invention avec une machine Magma C30® dotée d'un capteur SQUID.

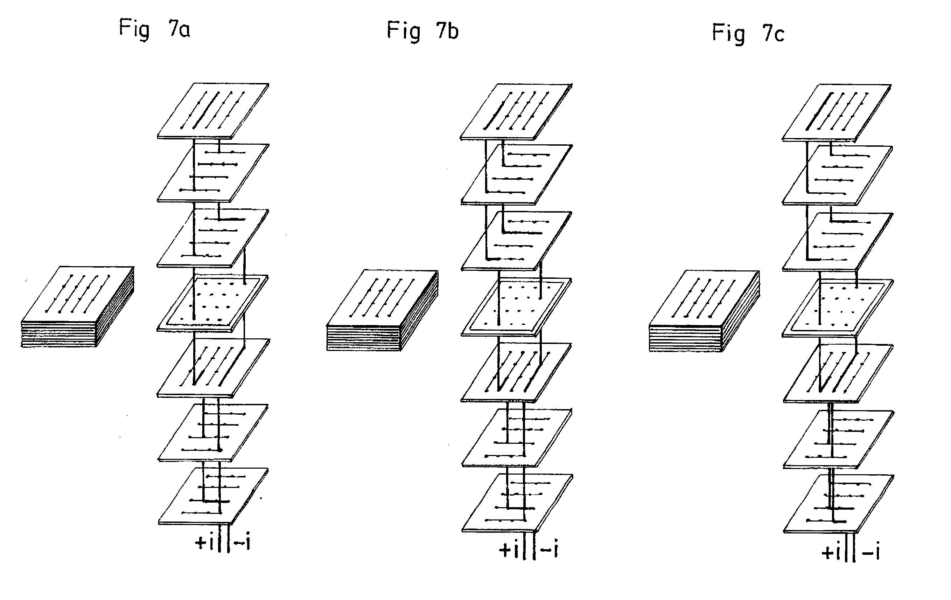

Les figures 7a, 7b, 7c représentent trois hypothèses de défaut dans le circuit électronique pouvant être formulées par l'opérateur, chaque hypothèse étant représentée par un enregistrement 29 du circuit électrique correspondant dans la base de données 30.

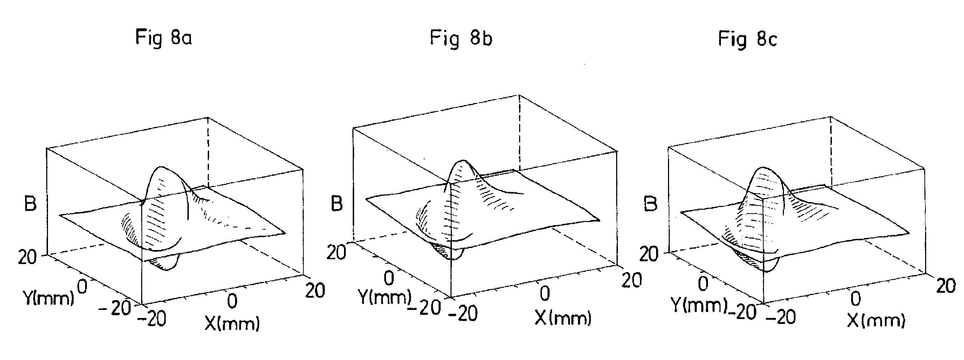

Les figures 8a, 8b, 8c sont les images simulées de la composante Bz correspondant aux trois hypothèses précédentes, et obtenues d'une part à partir du logiciel Flux 3D® d'analyse par éléments finis permettant d'obtenir les différentes matrices des différentes composantes du champ magnétique, représentées sous forme d'images de la même façon que l'image mesurée.

Comme on le voit, les images simulées peuvent être comparées ultérieurement à une image mesurée selon l'invention sur un dispositif présentant un défaut, et il est possible, à partir de ces différents images simulés, de trouver celle qui correspond le mieux à cette image mesurée, et donc au défaut.

## Revendications

1. Procédé de test d'un dispositif électronique, dans lequel le champ magnétique émis par au moins une circulation de courant électrique dans le dispositif électronique (39) est mesuré par une sonde (46) de mesure monodirectionnelle adaptée pour pouvoir délivrer un signal représentatif de la valeur d'une composante Bz dudit champ magnétique selon un axe ZZ' fixe prédéterminé par rapport à ladite sonde:

    - la sonde (46) étant approchée à une distance d0 en regard d'une face du dispositif électronique avec l'axe ZZ' sécant avec le dispositif électronique, et le dispositif électronique étant alimenté en énergie électrique et avec des signaux d'entrée prédéterminés appliqués sur des bornes d'entrées du dispositif électronique, pour chaque position (x, y) de l'axe ZZ' par rapport à la dite face, une première valeur Bz1 de la composante Bz du champ magnétique selon l'axe ZZ' est mesurée par la sonde (46) et enregistrée,

    **caractérisé en ce que**

    - la sonde (46) et le dispositif électronique sont ensuite déplacés l'un par rapport à l'autre par pivotement relatif autour d'un axe XX' orthogonal à l'axe ZZ' selon une amplitude angulaire $\alpha$ inférieure à 90°, la sonde (46) étant maintenue à la même distance d0 en regard de la même face du dispositif électronique, et, le dispositif électronique étant alimenté en énergie électrique et avec des signaux d'entrée prédéterminés, pour chaque position (x, y) de l'axe ZZ' par rapport à la dite face, une deuxième valeur Bz2 de la composante Bz du champ magnétique selon l'axe ZZ' est mesurée par la sonde (46) et enregistrée,
- puis la valeur d'une composante By du champ magnétique selon un axe YY' orthogonal aux axes ZZ' et XX' pour chaque position (x, y) de l'axe ZZ' est déterminée et enregistrée à partir de la première valeur Bz1 et de la deuxième valeur Bz2 obtenues.

2. Procédé selon la revendication 1, **caractérisé en ce que** la valeur de la composante By du champ magnétique est calculée selon la formule :

$$By = (Bz1.\cos\alpha - Bz2)/\sin\alpha$$

3. Procédé selon l'une des revendications 1 ou 2, **caractérisé en ce que** :

- la sonde (46) et le dispositif électronique sont déplacés l'un par rapport à l'autre par pivotement relatif autour de l'axe YY' selon une amplitude angulaire β inférieure à 90°, la sonde (46) étant maintenue à la même distance d0 en regard de la même face du dispositif électronique, et, le dispositif électronique étant alimenté en énergie électrique et avec des signaux d'entrée prédéterminés, pour chaque position (x, y) de l'axe ZZ' par rapport à la dite face, une troisième valeur Bz3 de la composante Bz du champ magnétique selon l'axe ZZ' est mesurée par la sonde (46) et enregistrée,
- puis la valeur d'une composante Bx du champ magnétique selon l'axe XX' pour chaque position (x, y) de l'axe ZZ' est déterminée et enregistrée à partir de la première valeur Bz1 et de la troisième valeur Bz3 obtenues.

4. Procédé selon la revendication 3, **caractérisé en ce que** la valeur de la composante Bx du champ magnétique est calculée selon la formule :

$$Bx = (Bz1.\cos\beta - Bz3)/\sin\beta$$

5. Procédé selon les revendications 1 à 4, **caractérisé en ce que** :

- une image, dite image mesurée (34), d'au moins une partie du dispositif électronique (39) est élaborée à partir de l'une des trois composantes Bx, By, Bz du champ magnétique émis par ce dispositif électronique, telle que déterminée à partir des mesures fournies par ladite sonde (46) pour différentes positions (x, y) de l'axe ZZ' de la sonde par rapport à la dite face,
- une pluralité d'images simulées (32) de ladite partie du dispositif électronique (39) sont élaborées par simulation, chaque image simulée correspondant à une image susceptible d'être obtenue de la même façon que l'image mesurée, à partir de valeurs calculées par simulation, pour chaque position (x, y) de l'axe ZZ' par rapport à la dite face, de la composante Bx, By, Bz correspondante du champ magnétique tel qu'il serait émis par ce dispositif électronique (39) en présence d'au moins un défaut de la circulation de courant dans ladite partie du dispositif électronique (39),
- les images simulées (32) sont comparées à l'image mesurée (34).

6. Procédé selon la revendication 5, **caractérisé en ce que** l'image mesurée de ladite partie du dispositif électronique (39) utilisée pour la comparaison correspond à une soustraction d'une image obtenue à partir de la composante Bx, By, Bz correspondante du champ magnétique émis par l'intégralité d'un dispositif électronique de référence correspondant au dispositif électronique (39) à tester mais exempt de défauts, cette composante étant mesurée pour chaque position (x, y) de l'axe ZZ' par rapport à la dite face, et d'une image obtenue à partir de la composante Bx, By, Bz correspondante du champ magnétique émis par l'intégralité du dispositif électronique (39) à tester, cette composante étant aussi mesurée pour chaque position (x, y) de l'axe ZZ' par rapport à la dite face, et **en ce que** chaque image simulée est élaborée par soustraction d'une image obtenue à partir de valeurs calculées par simulation, pour chaque position (x, y) de l'axe ZZ' par rapport à la dite face, de la composante Bx, By, Bz correspondante du champ magnétique tel qu'il serait émis par l'intégralité du dispositif électronique de référence, et d'une image obtenue à partir de valeurs calculées par simulation, pour chaque position (x, y) de l'axe ZZ' par rapport à la dite face, de la composante Bx, By, Bz correspondante du champ magnétique tel qu'il serait émis par l'intégralité du dispositif électronique (39) en présence d'au moins un défaut.

7. Procédé selon l'une des revendications 1 à 6, **caractérisé en ce qu'**on utilise une sonde (46) de mesure comprenant un capteur choisi parmi un capteur SQUID et un capteur magnétorésistif.

8. Procédé selon l'une des revendications 1 à 7, **caractérisé en ce que** le dispositif électronique (39) étant un assemblage électronique en trois dimensions, pour mesurer ladite première valeur Bz1, la sonde (46) est orientée avec l'axe ZZ' orthogonal à l'une des faces externes de cet assemblage électronique.

9. Procédé selon l'une des revendications 1 à 8, **caractérisé en ce que** la sonde (46) et le dispositif électronique (39) sont déplacés l'un par rapport à l'autre par pivotement relatif selon une amplitude angulaire supérieure à 10° et inférieure à 45° -notamment comprise entre 10° et 30°-.

10. Machine de test d'un dispositif électronique (39), comprenant :

   - une sonde (46) de mesure monodirectionnelle adaptée pour pouvoir délivrer un signal représentatif de la valeur d'une composante Bz selon un axe ZZ' fixe prédéterminé par rapport à ladite sonde, du champ magnétique émis au voisinage de la sonde (46) par au moins une circulation de courant électrique dans le dispositif électronique (39),
   - un support (44) de réception d'un dispositif électronique (39), et des moyens (53, 54) d'alimentation de ce dispositif électronique (39) en énergie électrique et avec des signaux d'entrée prédéterminés appliqués sur des bornes d'entrées du dispositif électronique (39),
   - un mécanisme apte à placer l'un par rapport à l'autre la sonde (46) et un dispositif électronique (39) reçu dans le support (44) de réception, avec l'axe ZZ' sécant avec le support (44) de réception,
   - des moyens (40) d'enregistrement des valeurs correspondant aux signaux délivrés par la sonde (46),

   **caractérisée en ce que** :

   - ledit mécanisme est adapté pour permettre de modifier, pour chaque position (x, y) de l'axe ZZ' par rapport au dispositif électronique, l'orientation de la sonde (46) et du dispositif électronique (39) l'un par rapport à l'autre, par pivotement relatif autour d'un axe XX' orthogonal à l'axe ZZ' selon une amplitude angulaire inférieure à 90°, la sonde (46) étant maintenue à une distance d0 en regard d'une même face du dispositif électronique (39),
   - ladite machine de test comprend des moyens (40) de calcul adaptés pour déterminer et enregistrer pour chaque position (x, y) de l'axe ZZ', la valeur d'une composante By du champ magnétique selon un axe YY' orthogonal aux axes ZZ' et XX', à partir d'une première valeur Bz1 de la composante Bz du champ magnétique selon l'axe ZZ' mesurée par la sonde (46) dans une première position angulaire relative par rapport à l'axe XX' de la sonde (46) et du dispositif électronique (39), et d'une deuxième valeur Bz2 de la composante Bz du champ magnétique selon l'axe ZZ' mesurée par la sonde (46) dans une deuxième position angulaire relative par rapport à l'axe XX' de la sonde (46) et du dispositif électronique (39), et à la même distance d0, lesdites première et deuxième positions angulaires par rapport à l'axe XX' étant séparées l'une de l'autre d'un angle inférieur à 90°.

11. Machine selon la revendication 10, **caractérisée en ce que** ledit mécanisme est adapté pour permettre de modifier l'orientation de la sonde (46) et du dispositif électronique (39) l'un par rapport à l'autre par pivotement relatif autour de l'axe YY' selon une amplitude angulaire inférieure à 90°, la sonde (46) étant maintenue à la même distance d0 en regard de la même face du dispositif électronique (39), et **en ce que** lesdits moyens (40) de calcul sont adaptés pour déterminer et enregistrer pour chaque position (x, y) de l'axe ZZ', la valeur d'une composante Bx du champ magnétique selon l'axe XX', à partir d'une première valeur Bz1 de la composante Bz du champ magnétique selon l'axe ZZ' mesurée par la sonde (46) dans une première position angulaire relative par rapport à l'axe YY' de la sonde (46) et du dispositif électronique (39), et d'une troisième valeur Bz3 de la composante Bz du champ magnétique selon l'axe ZZ' mesurée par la sonde (46) dans une deuxième position angulaire relative par rapport à l'axe YY' de la sonde (46) et du dispositif électronique (39), et à la même distance d0, lesdites première et deuxième positions angulaires par rapport à l'axe YY' étant séparées l'une de l'autre d'un angle inférieur à 90°.

12. Machine selon l'une des revendications 10 ou 11, **caractérisée en ce qu'**elle comprend en outre :

   - des moyens de génération d'une image, dite image mesurée, à partir de l'une des trois composantes Bx, By, Bz du champ magnétique émis par ce dispositif électronique (39), telle que déterminée à partir des mesures fournies par ladite sonde (46) pour différentes positions (x, y) de l'axe ZZ' de la sonde par rapport à la dite face,
   - des moyens (40) de calcul par simulation de valeurs calculées, pour chaque position (x, y) de l'axe ZZ' par rapport à la dite face, des trois composantes Bx, By, Bz du champ magnétique tel qu'il serait émis par ladite partie du dispositif électronique (39) en présence d'au moins un défaut de la circulation de courant dans ladite partie du dispositif électronique (39),
   - des moyens de génération d'une pluralité d'images simulées de ladite partie du dispositif électronique (39) par simulation, chaque image simulée correspondant à une image susceptible d'être obtenue de la même façon que l'image mesurée, à partir d'un jeu desdites valeurs calculées par simulation, pour chaque position (x, y) de l'axe ZZ' par rapport à la dite face, de la composante Bx, By, Bz correspondante du champ magnétique.

**13.** Machine selon l'une des revendications 10 à 12, **caractérisée en ce que** ladite sonde (46) comprend un capteur choisi parmi un capteur SQUID et un capteur magnétorésistif.

**14.** Machine selon l'une des revendications 10 à 13, **caractérisée en ce que** :

- le support (44) de réception est adapté pour pouvoir recevoir un dispositif électronique (39) formé d'un assemblage électronique en trois dimensions,
- le mécanisme est adapté pour permettre d'orienter la sonde (46) avec l'axe ZZ' orthogonal à l'une des faces externes d'un assemblage électronique reçu dans ledit support (44),

**en ce que** le support (44) de réception du dispositif électronique (39) est fixe par rapport à un bâti (41) et **en ce que** ledit mécanisme est adapté pour permettre de faire pivoter la sonde (46) par rapport à ce bâti (41).

**15.** Machine selon l'une des revendications 10 à 13, **caractérisée en ce que** :

- le support (44) de réception est adapté pour pouvoir recevoir un dispositif électronique (39) formé d'un assemblage électronique en trois dimensions,
- le mécanisme est adapté pour permettre d'orienter la sonde (46) avec l'axe ZZ' orthogonal à l'une des faces externes d'un assemblage électronique reçu dans ledit support (44),

et **en ce que** la sonde (46) est montée par rapport à un bâti (41) de façon à présenter une orientation de l'axe ZZ' fixe par rapport au bâti (41), **en ce que** ledit mécanisme est adapté pour permettre de faire pivoter par rapport au bâti (41) le support (44) de réception du dispositif électronique (39), et **en ce que** le dispositif électronique (39) reçu dans le support (44) est alimenté par l'intermédiaire d'un câble torsadé (54).

**Patentansprüche**

**1.** Verfahren zum Testen einer elektronischen Vorrichtung, wobei das magnetische Feld, das von mindestens einem elektrischen Stromflusses in der elektronischen Vorrichtung (39) ausgestrahlt wird, von einer Sonde (46) zur monodirektionalen Messung gemessen wird, die ausgelegt ist, um ein Signal senden zu können, das repräsentativ für den Wert einer Komponente Bz des magnetischen Feldes gemäß einer festen Achse ZZ' ist, die mit Bezug auf die Sonde vorbestimmt ist:

- wobei die Sonde (46) um einen Abstand d0 mit Bezug auf eine Seite der elektronischen Vorrichtung angenähert ist, wobei die Achse ZZ' die elektronische Vorrichtung schneidet, und wobei die elektronische Vorrichtung mit elektrischer Energie und mit vorbestimmten Eingangssignalen versorgt wird, die auf Eingangsklemmen der elektronischen Vorrichtung angelegt werden, für jede Position (x, y) der Achse ZZ' mit Bezug auf die Seite, wobei ein erster Wert Bz1 der Komponente Bz des magnetischen Felds gemäß der Achse ZZ' von der Sonde (46) gemessen und registriert wird,

**dadurch gekennzeichnet, dass**

- die Sonde (46) und die elektronische Vorrichtung dann mit Bezug aufeinander durch eine relative Drehung um eine Achse XX', orthogonal zur Achse ZZ', um eine Winkelamplitude $\alpha$ mit weniger als 90° verschoben werden, wobei die Sonde (46) im gleichen Abstand d0 mit Bezug auf die gleiche Seite der elektronischen Vorrichtung gehalten wird, und, wobei die elektronische Vorrichtung mit elektrischer Energie und mit vorbestimmten Eingangssignalen versorgt wird, für jede Position (x, y) der Achse ZZ' mit Bezug auf die Seite, ein zweiter Wert Bz2 der Komponente Bz des magnetischen Feldes gemäß der Achse ZZ' durch die Sonde (46) gemessen und registriert wird,
- dann wird der Wert einer Komponente By des magnetischen Feldesgemäß einer Achse YY', orthogonal zu den Achsen ZZ' und XX' für jede Position (x, y) der Achse ZZ' auf der Grundlage vom erhaltenen ersten Wert Bz1 und zweiten Wert Bz2 bestimmt und registriert.

**2.** Verfahren nach Anspruch 1, **dadurch gekennzeichnet, dass** der Wert einer Komponente By des magnetischen Feldes gemäß der folgenden Formel berechnet wird:

$$By = (Bz1.\cos\alpha - Bz2)/\sin\alpha$$

**3.** Verfahren nach einem der Ansprüche 1 oder 2, **dadurch gekennzeichnet, dass**

- die Sonde (46) und die elektronische Vorrichtung mit Bezug aufeinander durch eine relative Drehung um die Achse YY' um eine Winkelamplitude $\beta$ mit weniger als 90° verschoben werden, wobei die Sonde (46) im gleichen Abstand d0 mit Bezug auf die gleiche Seite der elektronischen Vorrichtung gehalten wird, und, wobei die elektronische Vorrichtung mit elektrischer Energie und mit vorbestimmten Eingangssignalen versorgt wird, für jede Position (x, y) der Achse ZZ' mit Bezug auf die Seite, ein dritter Wert Bz3 der Komponente Bz des magnetischen Feldes gemäß der Achse ZZ' von der Sonde (46) gemessen und registriert wird,

- dann wird der Wert einer Komponente Bx des magnetischen Feldes gemäß der Achse XX' für jede Position (x, y) der Achse ZZ' auf der Grundlage vom erhaltenen ersten Wert Bz1 und dritten Wert Bz3 bestimmt und registriert.

4. Verfahren nach Anspruch 3, **dadurch gekennzeichnet, dass** der Wert der Komponente Bx des magnetischen Feldesgemäß der folgenden Formel berechnet wird:

$$Bx = (Bz1.\cos\beta - Bz3)/\sin\beta$$

5. Verfahren nach Anspruch 1 bis 4, **dadurch gekennzeichnet, dass**

- ein Bild, genannt gemessenes Bild (34), mindestens eines Teils der elektronischen Vorrichtung (39) auf der Grundlage von einer der drei Komponenten Bx, By, Bz des magnetischen Feldes, ausgestrahlt von dieser elektronischen Vorrichtung, erstellt wird, wie auf der Grundlage von Messungen bestimmt, die von der Sonde (46) für verschiedene Positionen (x, y) der Achse ZZ' der Sonde mit Bezug auf die Seite geliefert werden.

- eine Vielzahl von simulierten Bildern (32) des Teils der elektronischen Vorrichtung (39) durch Simulation erstellt wird, wobei jedes simulierte Bild einem Bild entspricht, das auf die gleiche Weise wie das gemessene Bild erhalten werden kann, auf der Grundlage von Werten, die durch Simulation berechnet werden, für jede Position (x, y) der Achse ZZ' mit Bezug auf die Seite, der entsprechenden Komponente Bx, By, Bz des magnetischen Feldes, so wie es von dieser elektronischen Vorrichtung (39) ausgestrahlt wird, in Anwesenheit von mindestens einem Defekt des Stromflusses in dem Teil der elektronischen Vorrichtung (39),

- die simulierten Bilder (32) mit dem gemessenen Bild (34) verglichen werden.

6. Verfahren nach Anspruch 5, **dadurch gekennzeichnet, dass** das gemessene Bild des Teils der elektronischen Vorrichtung (39), das für den Vergleich verwendet wird, einer Subtraktion eines Bildes erhalten auf der Grundlage der entsprechenden Komponente Bx, By, Bz des magnetischen Feldes, ausgestrahlt von der Gesamtheit einer elektronischen Referenzvorrichtung an die zu testende, jedoch fehlerfreie elektronische Vorrichtung (39), entspricht, wobei diese Komponente für jede Position (x, y) der Achse ZZ' mit Bezug auf die Seite gemessen wird, und eines Bildes, erhalten auf der Grundlage der entsprechenden Komponente Bx, By, Bz des magnetischen Feldes, ausgestrahlt von der Gesamtheit der zu testenden elektronischen Vorrichtung (39), wobei diese Komponente auch für jede Position (x, y) der Achse ZZ' mit Bezug auf die Seite gemessen wird, und dadurch, dass jedes simulierte Bild durch Subtraktion eines Bildeserhalten auf der Grundlage von gerechneten Werten durch Simulation, für jede Position (x, y) der Achse ZZ' mit Bezug auf die Seite, von der entsprechenden Komponente Bx, By, Bz des magnetischen Feldes, so wie es durch die Gesamtheit der elektronischen Referenzvorrichtung ausgestrahlt wird, und eines Bildes, erhalten auf der Grundlage von berechneten Werten durch Simulation für jede Position (x, y) der Achse ZZ' mit Bezug auf die Seite, der entsprechenden Komponente Bx, By, Bz des magnetischen Feldes, so wie es durch die Gesamtheit der elektronischen Referenzvorrichtung (39) in Anwesenheit von mindestens einem Defekt ausgestrahlt wird, erstellt wird.

7. Verfahren nach einem der Ansprüche 1 bis 6, **dadurch gekennzeichnet, dass** eine Messsonde (46) verwendet wird, umfassend einen Sensor, der aus einem SQUID-Sensor und einem und einem magnetoresistiven Sensor ausgewählt wird.

8. Verfahren nach einem der Ansprüche 1 bis 7, **dadurch gekennzeichnet, dass** die elektronische Vorrichtung (39) eine elektronische Baugruppe in drei Dimensionen ist, um den ersten Wert Bz1 zu messen, wobei die Sonde (46) mit der Achse ZZ' orthogonal zu einer der äußeren Seiten dieser elektronischen Baugruppe ausgerichtet ist.

9. Verfahren nach einem der Ansprüche 1 bis 8, **dadurch gekennzeichnet, dass** die Sonde (46) und die elektronische Vorrichtung (39) mit Bezug aufeinander durch eine relative Drehung um eine Winkelamplitude mit mehr als 10° und weniger als 45° verschoben werden,-insbesondere zwischen 10° und 30°.

10. Maschine zum Test einer elektronischen Vorrichtung (39), umfassend:

- eine Sonde (46) zur monodirektionalen Messung, die ausgelegt ist, um ein Signal, das repräsentativ für den Wert einer Komponente Bz ist, gemäß einer festen vorbestimmten Achse ZZ' mit Bezug auf die Sonde vom magnetischen Feld, das in der Nähe der Sonde (46) ausgestrahlt wird, durch mindestens einen elektrischen Stromfluss in der elektronischen Vorrichtung (39) senden zu können,

- einen Träger (44) zur Aufnahme einer elektronischen Vorrichtung (39), und Mittel (53, 54) zur Versorgung dieser elektronischen Vorrichtung (39) mit elektrischer Energie und mit vorbestimmten Eingangssignalen, die auf Eingangsklemmen der elektronischen Vorrichtung (39) angelegt werden,

- einen Mechanismus, der dazu ausgelegt ist, um die Sonde (46) und eine elektronische Vorrichtung (39) mit Bezug zueinander anzubringen, aufgenommen im Aufnahmeträger (44) wobei sich die Achse ZZ' mit dem Aufnahmeträger (44) schneidet,

- Mittel (40) zur Registrierung der Werte, die den Signalen entsprechen, die von der Sonde (46) ausgestrahlt werden,

**dadurch gekennzeichnet, dass**

- der besagte Mechanismus ausgelegt ist, um zu ermöglichen, für jede Position (x, y) der Achse ZZ' mit Bezug auf die elektronische Vorrichtung die Ausrichtung der Sonde (46) und der elektronischen Vorrichtung (39) mit Bezug aufeinander durch eine relative Drehung um eine Achse XX', orthogonal zur Achse ZZ', um eine Winkelamplitude mit weniger als 90° zu modifizieren, wobei die Sonde (46) in einem Abstand d0 mit Bezug auf eine gleiche Seite der elektronischen Vorrichtung (39) gehalten wird,

- wobei die Testmaschine Mittel (40) zur Berechnung umfasst, die ausgelegt sind, um für jede Position (x, y) der Achse ZZ' den Wert einer Komponente By des magnetischen Feldes gemäß einer Achse YY', orthogonal zu den Achsen ZZ' und XX', auf der Grundlage von einem ersten Wert Bz1 der Komponente Bz des magnetischen Feldes gemäß der Achse ZZ' gemessen von der Sonde (46) in einer ersten relativen Winkelposition mit Bezug auf die Achse XX' der Sonde (46) und die elektronische Vorrichtung (39) und einen zweiten Wert Bz2 der Komponente Bz des magnetischen Feldes gemäß der Achse ZZ' gemessen von der Sonde (46) in einer zweiten relativen Winkelposition mit Bezug auf die Achse XX' der Sonde (46) und der elektronischen Vorrichtung (39) und im gleichen Abstand d0 zu bestimmen und zu registrieren, wobei die erste und die zweite Winkelposition mit Bezug auf die Achse XX' voneinander um einen Winkel von weniger als 90° getrennt sind.

11. Maschine nach Anspruch 10, **dadurch gekennzeichnet, dass** der Mechanismus ausgelegt ist, um zu ermöglichen, die Ausrichtung der Sonde (46) und der elektronischen Vorrichtung (39) mit Bezug aufeinander durch eine relative Drehung um die Achse YY' um eine Winkelamplitude mit weniger als 90° zu modifizieren, wobei die Sonde (46) im gleichen Abstand d0 mit Bezug auf die gleiche Seite der elektronischen Vorrichtung (39) gehalten wird, und dadurch, dass die Mittel (40) zur Berechnung ausgelegt sind, um für jede Position (x, y) der Achse ZZ' den Wert einer Komponente Bx des magnetischen Felds gemäß der Achse XX' auf der Grundlage von einem ersten Wert Bz1 der Komponente Bz des magnetischen Feldes gemäß der Achse ZZ' gemessen von der Sonde (46) in einer ersten relativen Winkelposition mit Bezug auf die Achse YY' der Sonde (46) und die elektronische Vorrichtung (39) und einen dritten Wert Bz3 der Komponente Bz des magnetischen Feldes gemäß der Achse ZZ', gemessen von der Sonde (46) in einer zweiten relativen Winkelposition mit Bezug auf die Achse YY' der Sonde (46) und der elektronischen Vorrichtung (39) und im gleichen Abstand d0 zu bestimmen und zu registrieren, wobei die erste und die zweite Winkelposition mit Bezug auf die Achse YY' voneinander um einen Winkel von weniger als 90° getrennt sind.

12. Maschine nach einem der Ansprüche 10 oder 11, **dadurch gekennzeichnet, dass** sie Folgendes umfasst:

- Mittel zur Erzeugung eines Bildes, genannt gemessenes Bild, auf der Grundlage von einer der drei Komponenten Bx, By, Bz des magnetischen Feldes, ausgestrahlt von dieser elektronischen Vorrichtung (39) wie aufgrund der Messungen bestimmt, die von der Sonde (46) für verschiedene Positionen (x, y) der Achse ZZ' der Sonde mit Bezug auf die Seite geliefert werden,

- Mittel (40) zur Berechnung durch Simulation von berechneten Werten für jede Position (x, y) der Achse ZZ' mit Bezug auf die Seite, der drei Komponenten Bx, By, Bz des magnetischen Feldes, so wie es vom Teil der elektronischen Vorrichtung (39) ausgestrahlt wird, in Anwesenheit von mindestens einem Defekt des Stromflusses in dem Teil der elektronischen Vorrichtung (39),

- Mittel zur Erzeugung einer Vielzahl von simulierten Bildern des Teils der elektronischen Vorrichtung (39) durch Simulation, wobei jedes simulierte Bild einem Bild entspricht, das auf die gleiche Weise wie das gemessene Bild erhalten werden kann, auf der Grundlage eines Satzes der Werte, berechnet durch Simulation, für jede Position (x, y) der Achse ZZ' mit Bezug auf die Seite, der entsprechenden Komponente Bx, By, Bz des magnetischen Felds.

**13.** Maschine nach einem der Ansprüche 10 bis 12, **dadurch gekennzeichnet, dass** die Sonde (46) einen Sensor umfasst, ausgewählt aus einem SQUID-Sensor und einem magnetoresistiven Sensor.

**14.** Maschine nach einem der Ansprüche 10 bis 13, **dadurch gekennzeichnet, dass**

- der Träger (44) zur Aufnahme ausgelegt ist, um eine elektronische Vorrichtung (39), gebildet aus einer elektronischen Baugruppe in drei Dimensionen, aufnehmen zu können,
- der Mechanismus ausgelegt ist, um zu ermöglichen, die Sonde (46) mit der Achse ZZ' orthogonal zu einer der äußeren Seiten einer elektronischen Baugruppe, aufgenommen in dem Träger (44), auszurichten,

dadurch, dass der Träger (44) zur Aufnahme der elektronischen Vorrichtung (39) mit Bezug auf einen Rahmen (41) befestigt ist, und dadurch, dass der Mechanismus ausgelegt ist, um zu ermöglichen, dass sich die Sonde (46) mit Bezug auf den Rahmen (41) dreht.

**15.** Maschine nach einem der Ansprüche 10 bis 13, **dadurch gekennzeichnet, dass**

- der Träger (44) zur Aufnahme ausgelegt ist, um eine elektronische Vorrichtung (39), gebildet aus einer elektronischen Baugruppe in drei Dimensionen, aufnehmen zu können,
- der Mechanismus ausgelegt ist, um zu ermöglichen, dass die Sonde (46) mit der Achse ZZ' orthogonal zu einer der äußeren Seiten einer elektronischen Baugruppe, aufgenommen in dem Träger (44), ausgerichtet wird,

und dadurch, dass die Sonde (46) mit Bezug auf einen Rahmen (41) montiert wird, um eine Ausrichtung der festen Achse ZZ' mit Bezug auf den Rahmen (41) aufzuweisen, dadurch, dass der Mechanismus ausgelegt ist, um zu ermöglichen, dass sich mit Bezug auf den Rahmen (41) der Träger (44) zur Aufnahme der elektronischen Vorrichtung (39) dreht, und dadurch, dass die elektronische Vorrichtung (39), aufgenommen im Träger (44), mit Hilfe eines (54) verdrillten Kabels versorgt wird.

**Claims**

**1.** A method for testing an electronic device, in which the magnetic field emitted by at least one circulation of electric current in the electronic device (39) is measured by a monodirectional measurement probe (46) adapted to be able to deliver a signal representative of the value of a component Bz of said magnetic field along a predetermined axis ZZ' which is fixed with respect to said probe:

- the probe (46) being brought to a distance d0 in front of one face of the electronic device with respect to the axis ZZ' intersecting with the electronic device, and the electronic device being supplied with electrical energy and with predetermined input signals applied to input terminals of the electronic device, for each position (x, y) of the axis ZZ' with respect to said face, a first value Bz1 of the component of the magnetic field Bz along the axis ZZ' is measured by the probe (46) and recorded,

**characterised in that**:

- the probe (46) and the electronic device are then displaced with respect to one another by relative pivoting about an axis XX' orthogonal to the axis ZZ' according to an angular amplitude $\alpha$ of less than 90°, the probe (46) being kept at the same distance d0 in front of the same face of the electronic device, and, the electronic device being supplied with electrical energy and with predetermined input signals, for each position (x, y) of the axis ZZ' with respect to said face, a second value Bz2 of the component Bz of the magnetic field along the axis ZZ' is measured by the probe (46) and recorded,
- then the value of a component By of the magnetic field along an axis YY' orthogonal to the axes ZZ' and XX' is determined and recorded for each position (x, y) of the axis ZZ' on the basis of the first value Bz1 and the second value Bz2 which have been obtained.

**2.** The method according to claim 1, **characterised in that** the value of the component By of the magnetic field is calculated according to the formula:

$$By = (Bz1.\cos\alpha - Bz2)/\sin\alpha.$$

**3.** The method according to one of claims 1 or 2, **characterized in that**:

- the probe (46) and the electronic device are displaced with respect to one another by relative pivoting about the axis YY' according to an angular amplitude $\beta$ of less than 90°, the probe (46) being kept at the same distance d0 in front of the same face of the electronic device, and, the electronic device being supplied with electrical energy and with predetermined input signals, for each position (x, y) of the axis ZZ' with respect to said face, a third value Bz3 of the component Bz of the magnetic field along the axis ZZ' is measured by the probe (46) and recorded,

- then the value of a component Bx of the magnetic field along an axis XX' is determined and recorded for each position (x, y) of the axis ZZ' on the basis of the first value Bz1 and the third value Bz3 which have been obtained.

4. The method according to claim 3, **characterised in that** the value of the component Bx of the magnetic field is calculated according to the formula:

$$Bx = (Bz1.\cos\beta - Bz3)/\sin\beta$$

5. The method according to one of claims 1 to 4, **characterised in that**:

- an image, called a measured image (34), of at least a part of the electronic device (39) is formed on the basis of one of the three components Bx, By, Bz of the magnetic field emitted by this electronic device, as determined on the basis of the measurements provided by said probe (46) for different positions (x, y) of the axis ZZ' of the probe with respect to said face,
- a plurality of simulated images (32) of said part of the electronic device (39) are formed by simulation, each simulated image corresponding to an image capable of being obtained in the same way as the measured image, on the basis of values calculated by simulation, for each position (x, y) of the axis ZZ' with respect to said face, of the corresponding component Bx, By, Bz of the magnetic field as would be emitted by this electronic device (39) in the presence of at least one fault of the circulation of current in said part of the electronic device (39),
- the simulated images (32) are compared with the measured image (34).

6. The method according to claim 5, **characterised in that** the measured image of said part of the electronic device (39), which is used for the comparison, corresponds to a subtraction of an image obtained on the basis of the corresponding component Bx, By, Bz of the magnetic field emitted by the entirety of a reference electronic device corresponding to the electronic device (39) to be tested but free of faults, this component being measured for each position (x, y) of the axis ZZ' with respect to said face, and of an image obtained on the basis of the corresponding component Bx, By, Bz of the magnetic field emitted by the entirety of the electronic device (39) to be tested, this component also being measured for each position (x, y) of the axis ZZ' with respect to said face, and **characterised in that** each simulated image is formed by subtraction of an image obtained on the basis of values calculated by simulation, for each position (x, y) of the axis ZZ' with respect to said face, of the corresponding component Bx, By, Bz of the magnetic field as would be emitted by the entirety of the reference electronic device, and of an image obtained on the basis of values calculated by simulation, for each position (x, y) of the axis ZZ' with respect to said face, of the corresponding component Bx, By, Bz of the magnetic field as would be emitted by the entirety of the electronic device (39) in the presence of at least one fault.

7. The method according to one of claims 1 to 6, **characterised in that** a measurement probe (46) comprising a sensor selected from a SQUID sensor and a magnetoresistive sensor is used.

8. The method according to one of claims 1 to 7, **characterised in that**, the electronic device (39) being an electronic assembly in three dimensions, in order to measure said first value Bz1, the probe (46) is oriented with the axis ZZ' orthogonal to one of the external faces of this electronic assembly.

9. The method according to one of claims 1 to 8, **characterised in that** the probe (46) and the electronic device (39) are displaced with respect to one another by relative pivoting according to an angular amplitude of more than 10° and less than 45° - in particular lying between 10° and 30°.

10. A machine for testing an electronic device (39), comprising:

- a monodirectional measurement probe (46) adapted to be able to deliver a signal representative of the value of a component Bz, along a predetermined axis ZZ' which is fixed with respect to said probe, of the magnetic field emitted in the vicinity of the probe (46) by at least one circulation of electric current in the electronic device (39),
- a support (44) for receiving an electronic device (39), and means (53,54) for supplying this electronic device (39) with electrical energy and with predetermined input signals applied to input terminals of the electronic device (39),
- a mechanism suitable for placing the probe (46) and an electronic device (39) received in the reception support (44) with respect to one another, with respect to the axis ZZ' intersecting with the reception support (44),
- means (40) for recording values corresponding to the signals delivered by the probe (46),

**characterised in that**:

- said mechanism is configured to make it possible to modify, for each position (x, y) of the axis ZZ' with respect to the electronic device, the orientation of the probe (46) and the electronic device (39) with respect to one another, by relative pivoting about an axis XX' orthogonal to the axis ZZ' according to an angular amplitude of less than 90°, the probe (46) being kept at a distance d0 in front of the same face of the electronic device (39),

- said test machine comprises calculation means (40) configured to determine and record, for each position (x, y) of the axis ZZ', the value of a component By of the magnetic field along an axis YY' orthogonal to the axes ZZ' and XX', on the basis of a first value Bz1 of the component Bz of the magnetic field along the axis ZZ' as measured by the probe (46) in a first relative angular position of the probe (46) and of the electronic device (39) with respect to the axis XX', and of a second value Bz2 of the component Bz of the magnetic field along the axis ZZ' as measured by the probe (46) in a second relative angular position of the probe (46) and of the electronic device (39) with respect to the axis XX', and at the same distance d0, said first and second angular positions with respect to the axis XX' being separated from one another by an angle of less than 90°.

11. The machine according to claim 10, **characterised in that** said mechanism is configured to make it possible to modify the orientation of the probe (46) and the electronic device (39) with respect to one another, by relative pivoting about the axis YY' according to an angular amplitude of less than 90°, the probe (46) being kept at the same distance d0 in front of the same face of the electronic device (39), and **characterised in that** said calculation means (40) are configured to determine and record, for each position (x, y) of the axis ZZ', the value of a component Bx of the magnetic field along the axis XX', on the basis of a first value Bz1 of the component Bz of the magnetic field along the axis ZZ' as measured by the probe (46) in a first relative angular position of the probe (46) and of the electronic device (39) with respect to the axis YY', and of a third value Bz3 of the component Bz of the magnetic field along the axis ZZ' as measured by the probe (46) in a second relative angular position of the probe (46) and of the electronic device (39) with respect to the axis YY', and at the same distance d0, said first and second angular positions with respect to the axis YY' being separated from one another by an angle of less than 90°.

12. The machine according to one of claims 10 or 11, **characterised in that** it furthermore comprises:

- means for generating an image, called a measured image on the basis of one of the three components Bx, By, Bz of the magnetic field emitted by this electronic device (39), as determined on the basis of the measurements provided by said probe (46) for different positions (x, y) of the axis ZZ' of the probe with respect to said face,

- means (40) for calculating calculated values by simulation, for each position (x, y) of the axis ZZ' with respect to said face, of the three components Bx, By, Bz of the magnetic field as would be emitted by said part of the electronic device (39) in the presence of at least one fault of the circulation of current in said part of the electronic device (39),

- means for generating a plurality of simulated images of said part of the electronic device (39) by simulation, each simulated image corresponding to an image capable of being obtained in the same way as the measured image, on the basis of a set of said values calculated by simulation, for each position (x, y) of the axis ZZ' with respect to said face, of the corresponding component Bx, By, Bz of the magnetic field.

13. The machine according to one of claims 10 to 12, **characterised in that** said probe (46) comprises a sensor selected from a SQUID sensor and a magnetoresistive sensor.

14. The machine according to one of claims 10 to 13, **characterised in that**:

- the reception support (44) is arranged to be able to receive an electronic device (39) formed by an electronic assembly in three dimensions,

- the mechanism is configured to make it possible to orientate the probe (46) with the axis ZZ' orthogonal to one of the external faces of an electronic assembly received in said support (44),

**characterised in that** the reception support (44) of the electronic device (39) is fixed with respect to a frame (41) and **characterised in that** said mechanism is configured to make it possible to pivot the probe (46) with respect to this frame (41).

15. The machine according to one of claims 10 to 13, **characterised in that**:

- the support (44) for receiving the electronic device (39) is formed by an electronic assembly in three dimensions,

- the mechanism is configured to make it possible to orientate the probe (46) with the orthogonal axis ZZ' to one of the external faces of an electronic assembly received in said support (44),

**characterised in that** the probe (46) is mounted with respect to a frame (41) so as to have a fixed orientation of the axis ZZ' with respect to the frame (41), **characterised in that** the mechanism is configured to make it possible to pivot the support (44) for receiving the electronic device (39) with respect to the frame (41), and **characterised in that** the electronic device (39) received in the support (44) is supplied by means of a twisted cable (54).

Fig 1

Fig2

Fig 3

Fig 4a

Fig 4b

Fig 6

Fig 5b

Fig 5a

Fig 7c

Fig 7b

Fig 7a

Fig 8a     Fig 8b     Fig 8c

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2003001596 A

**Littérature non-brevet citée dans la description**

• **INFANTE F.** Failure Analysis for System in Package devices using Magnetic Microscopy. *THESIS,* 21 Mai 2008